# EUROPÄISCHE PATENTANMELDUNG

(11) **EP 1 018 760 A1**
(43) Veröffentlichungstag der Anmeldung: **12.07.2000**
(21) Anmeldenummer: 99810009.3
(22) Anmeldetag: 07.01.1999
(51) Int. Cl.: H01L 21/56, H01L 23/31

(54) **Verfahren und Vorrichtung zum Verkapseln eines elektronischen Bauteils, insbesondere eines Halbleiterchips**

(71) Anmelder: Alphasem AG, 8572 Berg (CH)
(72) Erfinder: Wirz, Gustav, 8572 Andhausen (CH); Herbst, Wolfgang, Dr., 78464 Konstanz/Egg (DE); Ritzmann, Heinz, 8572 Berg (CH)
(74) Vertreter: Wenger, René

(57) **Zusammenfassung**

Zum Verkapseln eines elektronischen Bauteils, insbesondere eines Halbleiterchips, wird das Bauteil (3) im Abstand auf einen flächigen Träger (2) befestigt. Dazu wird auf dem Träger eine Elastomerschicht (4, 9) aufgebracht, welche die unterschiedlichen Wärmeausdehnungskoeffizienten zwischen Träger und Bauteil ausgleicht. Ein Puffermaterial und/oder ein Klebstoff wird in flüssiger oder pastöser Form aus einem Dispenser aufgetragen und das Bauteil wird bei Raumtemperatur auf das Puffermaterial und/oder den Klebstoff aufgesetzt. Vor dem endgültigen Aushärten wird das Puffermaterial und/oder der Klebstoff zuerst einer Vorhärtung unterzogen. Anschliessend wird das Bauteil mittels elektrischer Leiter mit Kontaktstellen am Träger verbunden und zuletzt erfolgt ein Umhüllen aller verbleibenden Hohlräume inklusive der elektrischen Leiter mit einer Schutzmasse. Das Auftragen des Puffermaterials und/oder des Klebstoffs mit einem Dispenser bewirkt eine erhebliche Rationalisierung.

## Beschreibung

Die Erfindung betrifft ein Verfahren zum Verkapseln eines elektronischen Bauteils, insbesondere eines Halbleiterchips, gemäss dem Oberbegriff von Anspruch 1. Derartige Verfahren erlauben die Herstellung sogenannter Chip-Scale-Packages (CSP), bei denen das fertige mit Anschlussteilen versehene Halbleiterelement nur unwesentlich grösser ist als der rohe Siliciumchip.

Die Grundidee besteht dabei darin, dass zwischen dem Träger und dem Bauteil eine Puffermasse, beispielsweise aus einem Silikon Elastomer angeordnet wird, welche die unterschiedlichen Längenausdehnungskoeffizienten der Werkstoffe kompensiert. Damit stehen auch die Lötverbindungen des eingebauten Halbleiterchips bei Erwärmung nur unter geringer Beanspruchung. Die Lebensdauer und Zuverlässigkeit derartiger Chip-Scale-Packages ist daher verhältnismässig hoch. Bekannte Herstellungsverfahren sind beispielsweise beschrieben in "Semiconductor International", November 1997, Seite 48, oder in US A-5-659-952 oder US-A-5-679-977. Trotz der verbesserten Eigenschaften des Endproduktes, sind die bekannten Verfahren aber noch relativ aufwendig und erlauben keine rationelle Fertigung. Es sind insbesondere zahlreiche Einzelschritte mit einem vergleichsweise hohen apparativen Aufwand erforderlich. Es ist daher eine Aufgabe der Erfindung, ein Verfahren der Eingangs genannten Art zu schaffen, bei dem weniger Prozessschritte erforderlich sind. Ausserdem soll beim Platzieren des Bauteils auf mechanische Anlageteile und/oder auf das Bauteil selbst keine unnötige Wärmeeinwirkung erfolgen, weil mikromechanische Prozesse unter gleichzeitiger Wärmeeinwirkung nur schwer zu handhaben sind.

Diese Aufgabe wird erfindungsgemäss mit einem Verfahren gelöst, das die Merkmale im Anspruch 1 aufweist. Das Puffermaterial und/oder ein Klebstoff wird dabei in flüssiger oder pastöser Form aus einem Dispenser aufgetragen. Damit kann zumindest ein bisher erforderlicher Arbeitsschritt eingespart werden, nämlich das Aufdrucken eines Klebstoffes in einem Schablonendruckverfahren. Das Bauteil selbst wird bei Raumtemperatur auf das Puffermaterial und/oder auf den Klebstoff aufgesetzt und nicht wie bisher im aufgeheizten Zustand. Unter dem Begriff "Raumtemperatur" wird dabei eine Temperatur verstanden, die in Arbeitsräumen entsprechnd der geltenden Normen in der Klimatechnik herrscht und die etwa im Temperaturspektrum von 10°C bis 45°C, vorzugsweise von 16°C bis 26°C angesiedelt ist. Damit wird der Durchsatz pro Zeiteinheit verbessert, weil keine Aufheizzeit für das Bauteil eingeplant werden muss. Mechanische Anlagenteile und/oder Messinstrumente werden nicht durch Wärmeeinwirkung beeinträchtigt.

Nach dem Aufsetzen des Bauteils kann das Puffermaterial und/oder der Klebstoff einer Vorhärtung und/oder einer Aushärtung unterzogen werden und zwar vorteilhaft auf der gleichen Anlage wie das Aufsetzen des Bauteils. Dadurch wird auf besonders vorteilhafte Weise der Umstand ausgenützt, dass bei den hier eingesetzten Klebstoffen das Zusammenfügen der zu verbindenden Teile und das Härten des Klebstoffes nicht zwingend zusammenfallen müssen. Durch die zeitliche Trennung kann das Vorhärten und/oder das Aushärten in einem Anlagenbereich erfolgen, bei dem Wärmeentwicklung weniger problematisch ist. Nach dem Vorhärten oder Aushärten können die verbundenen Einheiten ohne Risiko einer gegenseitigen Verschiebung von Träger und Bauteil zu beliebigen anderen Arbeitsstationen transportiert werden.

Eine wesentliche Prozessvereinfachung kann erreicht werden, indem zuerst mehrere Puffernocken in einem Schablonendruckverfahren befestigt werden, die Puffernocken ausgehärtet werden und vor dem Aufsetzen des Bauteils mit dem Dispenser auf und/oder neben mehreren Puffernocken Klebstoff aufgetragen wird. Bei diesem Verfahren können bestehende Schablonendrucker für das Auftragen der Puffernocken (Nubbins) verwendet werden. Dagegen erfolgt der Auftrag des Klebstoffs auf erheblich einfachere Weise mit dem Dispenser. Vorteilhaft wird gleichzeitig aus mehreren Dispenseröffnungen Klebestoff aufgetragen. Denkbar wäre unter Umständen aber auch ein Dispenser, der in rascher Folge hintereinander eine Gruppe von Puffernocken mit einem Klebstoff beschichtet.

Bei geeigneter Materialwahl können mit dem Dispenser aber auch die Puffernocken selbst auf den Träger abgesetzt und befestigt werden. Anschliessend kann jeder Puffernocken mit einer Kelbstoffschicht versehen werden. Dies kann entweder mit einem separaten Dispenser oder mit dem gleichen Dispenser erfolgen.

Eine weitere wesentliche Vereinfachung des Prozesses kann schliesslich dadurch erreicht werden, dass mit dem Dispenser auf den Träger ein Klebstoff aufgetragen wird, der gleichzeitig als Puffermaterial dient. Damit entfällt die Aufteilung in zwei separate Werkstoffe, was den Prozess insgesamt vereinfacht. Der Klebstoff kann dabei in der Form einzelner Pufferkörper aufgetragen werden, welche nach dem Aufsetzen des Bauteils vereinzelt bleiben. Die Zwischenräume werden dabei später zusammen mit der Umhüllung der Verdrahtungsstellen mit einer Schutzmasse ausgefüllt. Alternativ ist es aber auch denkbar, dass der Klebstoff mit dem Dispenser als Klebstoffmuster aufgetragen wird, das sich nach dem Aufsetzen des Bauteils zu einer homogenen Schicht verbindet. Dadurch werden Lufteinschlüsse verhindert und ein nachträgliches Ausfüllen der Zwischenräume ist nicht mehr nötig. Derartige Klebstoffmuster sind in der Halbleiter-Verkaspelungstechnik bereits bekannt.

Weitere Vorteile können erreicht werden, wenn das Auftragen des Puffermaterials und/oder des Klebstoffs mit dem Dispenser unmittelbar vor dem Aufsetzen des Bauteils auf der gleichen Maschine erfolgt. Vorteilhaft wird dabei auch der Träger auf dem gleichen Transportsystem am Dispenser und an der Aufsetzvorrichtung für das Bauteil vorbeigeführt. Einerseits können dabei die beiden Arbeitsschritte exakt aufeinander abgestimmt werden und die Trockenzeit kann besser kontrolliert werden. In der gleichen Maschine und auf dem gleichen Transportsystem ist ein ruckfreier und sanfter Transport möglich, wodurch die Gefahr einer unbeabsichtigten Verschiebung des Bauteils aus der Soll-Lage stark reduziert wird. Vor dem Aufsetzen wird das Bauteil vorteilhaft lagemässig justiert.

Eine Verbesserung der Planarität von Bauteil und Träger kann dadurch erreicht werden, dass der Träger wenigstens beim Aufsetzen des Bauteils mittels Unterdruck auf einer Auflagefläche fixiert wird.

Zur Verbesserung der Fertigungsrationalität werden vorteilhaft auf dem gleichen Träger Gruppen von Bauteilen befestigt. Dazu werden jeweils mehrere Bauteile nacheinander zu einer Gruppe abgesetzt. Die ganze Gruppe kann dann gleichzeitig einem Anpressdruck und/oder einer Wärmebehandlung ausgesetzt werden. Dieses gruppenweise Anpressen und/oder Heizen kann auch bei alternativen Verkapselungsprozessen eingesetzt werden, bei denen das Bauteil nicht bei Raumtemperatur abgesetzt wird. Die gleichzeitige Bearbeitung der Bauteile kann über gemeinsam betätigte Einzelwerkzeuge erfolgen, wie z.B. einzelne Anpressstempel, welche aber gleichzeitig betätigt werden. Alternativ kann es sich aber auch um ein gemeinsames Werkzeug handeln, das die ganze Gruppe gleichzeitig beaufschlagt, wie z.B. ein gemeinsamer Pressstempel von entsprechender Grösse.

Die Erfindung betrifft auch eine Vorrichtung zur Durchführung des beschriebenen Verfahrens, welche durch die Merkmale im Anspruch 15 gekennzeichnet ist. Mit geringfügigen baulichen Adaptionen können dabei vorteilhaft bekannte Bestückungsautomaten (Die bonder) eingesetzt werden, wie sie z.B. durch die WO 97/32460 bekannt geworden sind.

Die Dispenserstation kann einen Dispenser mit mehreren Ausgabeöffnungen oder aber einen Dispenser mit wenigstens einer beweglichen Dispenseröffnung aufweisen, mit dessen Hilfe durch gleichzeitige Bewegung und Abgabe des Mittels ein bestimmtes Muster gezeichnet werden kann.

Eine besonders kompakte Fertigungseinheit kann erzielt werden, wenn in Transportrichtung nach der Aufsetzstation eine Vorhärtestation und/oder eine Aushärtestation angeordnet ist, in welcher die aus Träger und Bauteil bestehende Einheit mittels elektromagnetischer Strahlen, insbesondere mittels Infrarotstrahlen oder Ultraviolettstrahlen beaufschlagbar ist. Die Halbleiterbauteile können diese Vorhärtestation oder Aushärtestation im gleichen Arbeitstakt durchlaufen wie die Dispenserstation und die Aufsetzstation.

Weitere Vorteile und Einzelmerkmale der Erfindung ergeben sich aus der nachfolgenden Beschreibung und aus den Zeichnungen. Es zeigen
- Figur 1: einen Querschnitt durch ein Chip-Scale-Package mit einzelnen Puffernocken,
- Figur 2: einen Querschnitt durch ein Chip-Scale-Package mit einer homogenen Pufferschicht,
- Figur 3: ein erstes Herstellungsverfahren in schematischen Einzeldarstellungen,
- Figur 4: ein zweites Herstellungsverfahren in schematischen Einzeldarstellungen,
- Figur 5: eine Draufsicht auf einen Träger mit einer Gruppe von Absetzpositionen für Bauteile,
- Figur 6: eine schematische Darstellung eines Nadeldispensers mit mehreren Abgabeöffnungen,
- Figur 7: stark vergrösserte Puffernocken mit Klebstoffschicht in Seitenansicht,
- Figur 8: die schematische Darstellung einer Justierstation,
- Figur 9: die schematische Darstellung einer Aufsetzstation, und
- Figur 10: eine schematische Darstellung eines Aufsetzvorgangs.

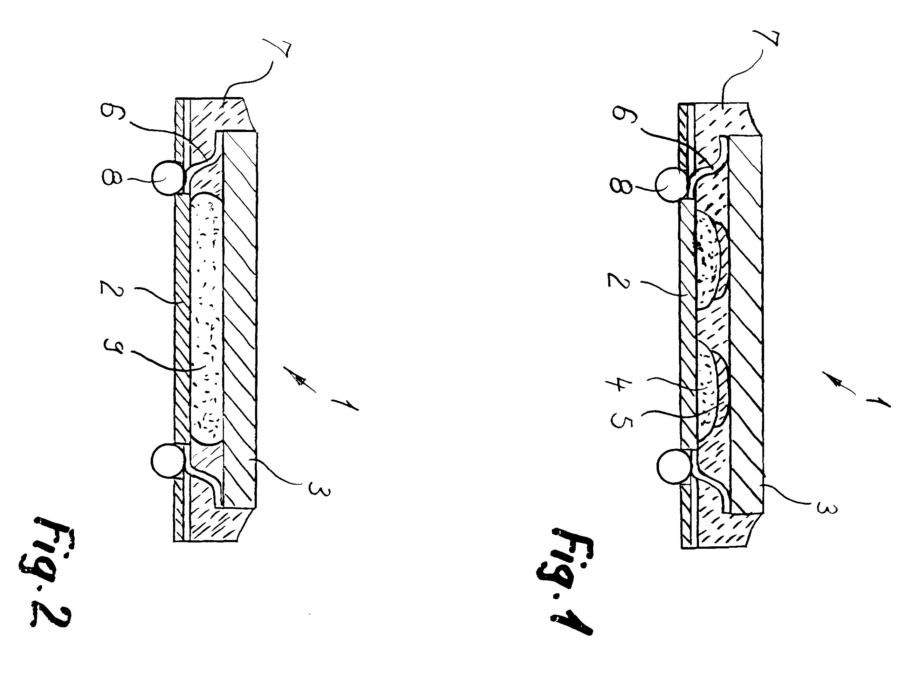

Anhand der Figuren 1 und 2 wird zunächst der prinzipielle Aufbau eines Chip-Scale-Package 1 in zwei unterschiedlichen Varianten beschrieben. Beim Ausführungsbeispiel gemäss Figur 1 ist ein vorzugsweise flexibler Träger 2 aus Kunststoffmaterial, z.B. Polyimidfolie mit einer Mehrzahl von Puffernocken 4 versehen. Diese bestehen beispielsweise aus einem Silikon Elastomer. Auf diesen Puffernocken ist mit Hilfe eines Klebstoffs 5 ein Siliciumchip 3 befestigt. Auf der freibleibenden Rückseite des Trägers 2 sind Kontaktstellen in der Form von Lötkugeln 8 angeordnet. Diese sind über elektrische Leiter 6 mit dem Chip 3 verdrahtet. Sämtliche Hohlräume zwischen den Puffernocken 4 sowie der Bereich um die elektrischen Leiter 6 sind mit einer Schutzmasse 7 beispielsweise aus Kunststoffmaterial ausgefüllt. Das Anbringen und Verbinden der elektrischen Leiter, das Befestigen der Lötkugeln und auch das Ausfüllen der Zwischenräume ist dem Fachmann an sich bereits bekannt und wird im Folgenden nicht mehr näher beschrieben. Es wird in diesem Zusammenhang hingewiesen auf Lawing, "Preventing voids in µBGA® packages", in Chip Scale Review März 1998. Brauchbare Silikon Elastomere werden beispielsweise von der Firma Dow Corning, Midland, Michigan USA hergestellt, nämlich unter der Bezeichnung Dow Corning 7910 für den Klebstoff, Dow Corning 6910 für das Puffermaterial und Dow Corning 6811 für die Schutzmasse.

Beim Ausführungsbeispiel gemäss Figur 2 unterscheidet sich das Chip-Scale-Package 1 von aussen praktisch nicht von demjenigen gemäss Figur 1. Anstelle von einzelnen Puffernocken übernimmt jedoch eine homogene Klebstoffschicht 9 die Funktion des Puffermaterials und des Abstandhalters. Nach dem Verbinden der elektrischen Leiter 6 müssen diese nur noch im Aussenbereich mit der Schutzmasse 7 verkapselt werden. Die Gefahr von schädlichen Einflüssen von Feuchtigkeit wird dadurch stark reduziert.

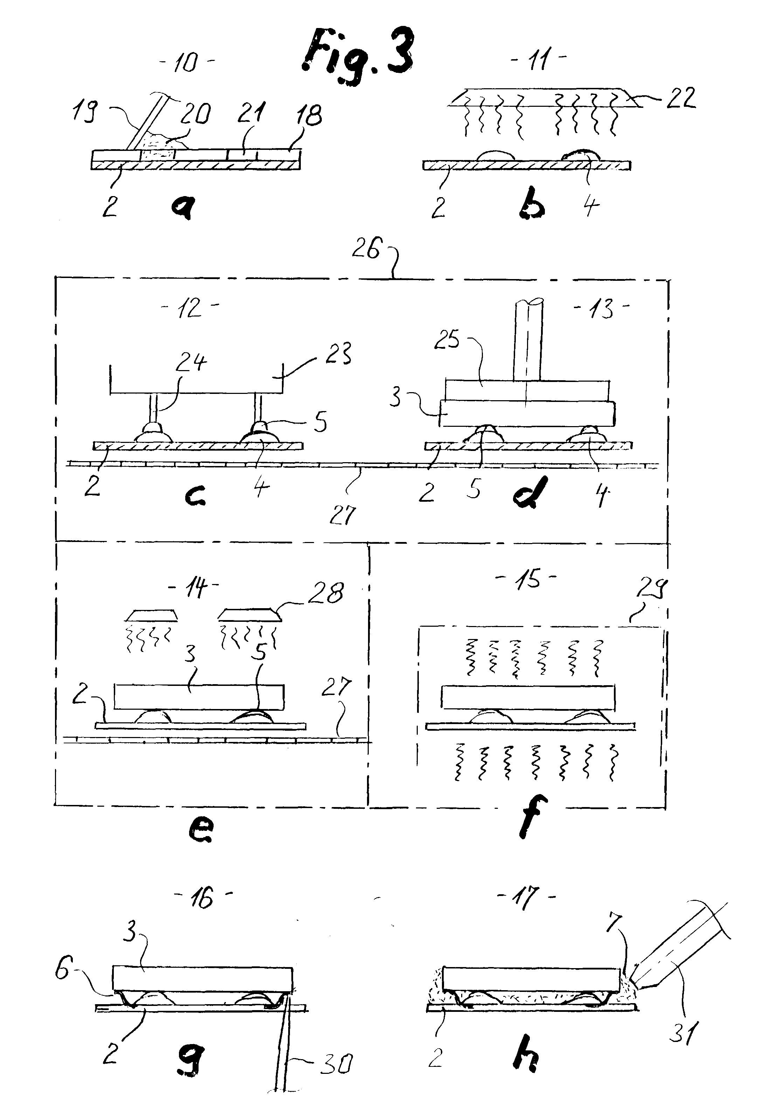

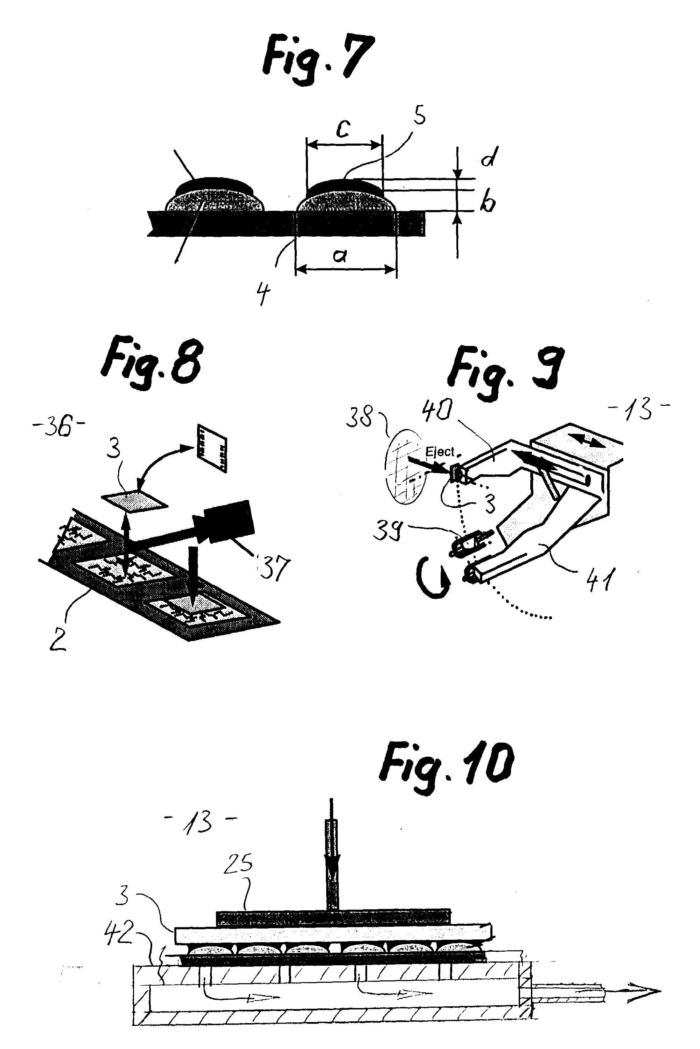

Das in Figur 3 schematisch dargestellte Herstellungsverfahren zeigt die wesentlichen Arbeitsstationen, deren Funktion anschliessend erläutert wird. In Figur 3a werden an einer Druckstation mit Hilfe eines Schablonendruckverfahrens einzelne Puffernocken auf den Träger 2 aufgedruckt. Zu diesem Zweck wird eine Schablone 18 gegen den Träger gepresst, welche mit Öffnungen 21 versehen ist. Eine Puffermasse 20 wird mit einem Rakel 19 in die Öffnungen gepresst, wodurch die einzelnen Puffernocken gebildet werden.

Die frisch geformten Puffernocken 4 werden gemäss Figur 3b an einer ersten Härtestation 11 mit einer Wärmequelle 22 ausgehärtet.

Ein derart vorbereiteter Träger 2 gelangt jetzt auf einem Transportsystem 27 in eine Maschine 26, in welcher nebeneinander eine Dispenserstation 12, eine Aufsetzstation 13 und gegebenenfalls auch noch eine Vorhärtestation 14 und/oder eine Aushärtestation 15 angeordnet sind. An der Dispenserstation 12 gemäss Figur 3c wird mit einem Nadeldispenser 23 aus mehreren Röhrchen 24 gleichzeitig ein Klebstoff 5 auf jedem Puffernocken 4 abgesetzt. Dabei wird ein Klebstoff gewählt, mit dessen Hilfe bei Raumtemperatur geklebt werden kann.

An der Aufsetzstation 13 gemäss Figur 3d wird der Chip 3 mit einem Aufsetzkopf 25 auf die beschichteten Puffernocken 4 abgesetzt. Nach einem ruckfreien schonenden Weitertransport zur Vorhärtestation 14 gemäss Figur 3e erfolgt eine Vorhärtung, vorzugsweise mit Hilfe von Infrarotstrahlern 28, welche den Träger 2 von oben bestrahlen.

Erst nach dieser Vorhärtung wird gemäss Figur 3f die ganze Einheit an einer Härtestation 15 mit einem Ofen 29 mit einer Temperatur von beispielsweise 150°C ausgehärtet.

Anstelle der Vorhärtestation könnte aber auch unmittelbar die endgültige Aushärtestation treten. Beide Stationen, also die Vorhärtestation und/oder die Aushärtestation könnten in bestimmten Fällen auch separate Anlagenteile sein, die nicht mit dem gleichen Transportsystem durchlaufen werden können.

Anschliessend werden gemäss Figur 3g an einer Verbindungsstation 16 die elektrischen Leiter 6 mit einem Verbindungswerkzeug 30 an den Chip 3 angeschlossen. Dieser Prozess (Lead bonding) ist dem Fachmann an sich bereits bekannt.

Schliesslich erfolgt gemäss Figur 3h das Verkapseln der ganzen Einheit mit einer Schutzmasse 7 die aus einem Füllwerkzeug 31 abgegeben wird. Dabei werden die Hohlräume zwischen den einzelnen Puffernocken 4 und auch die Verdrahtungen ausgefüllt bzw. umhüllt.

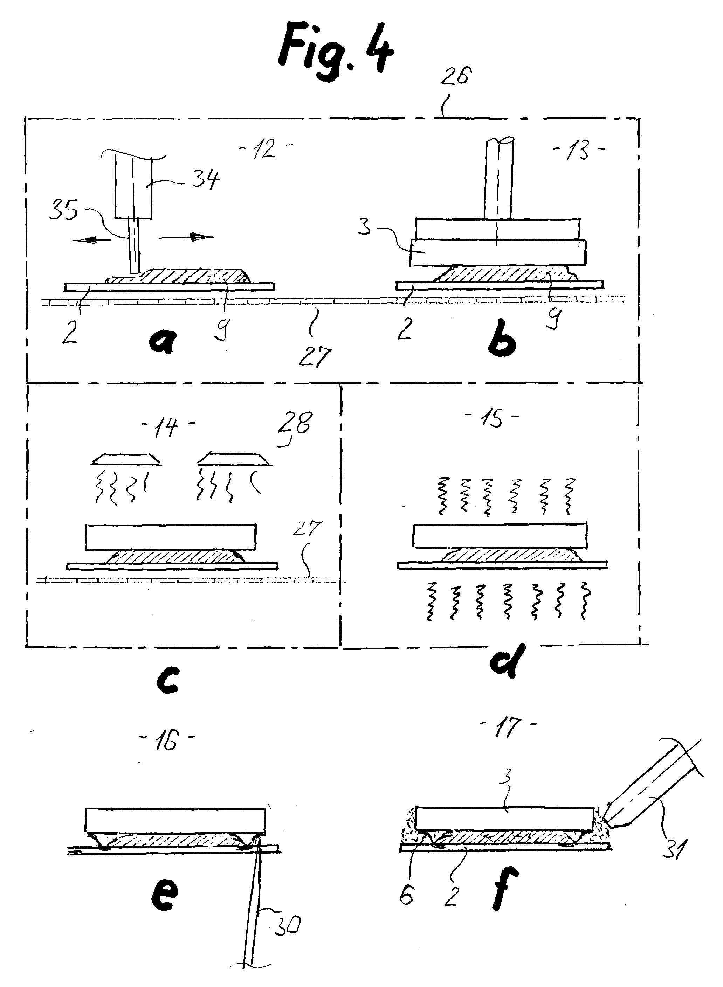

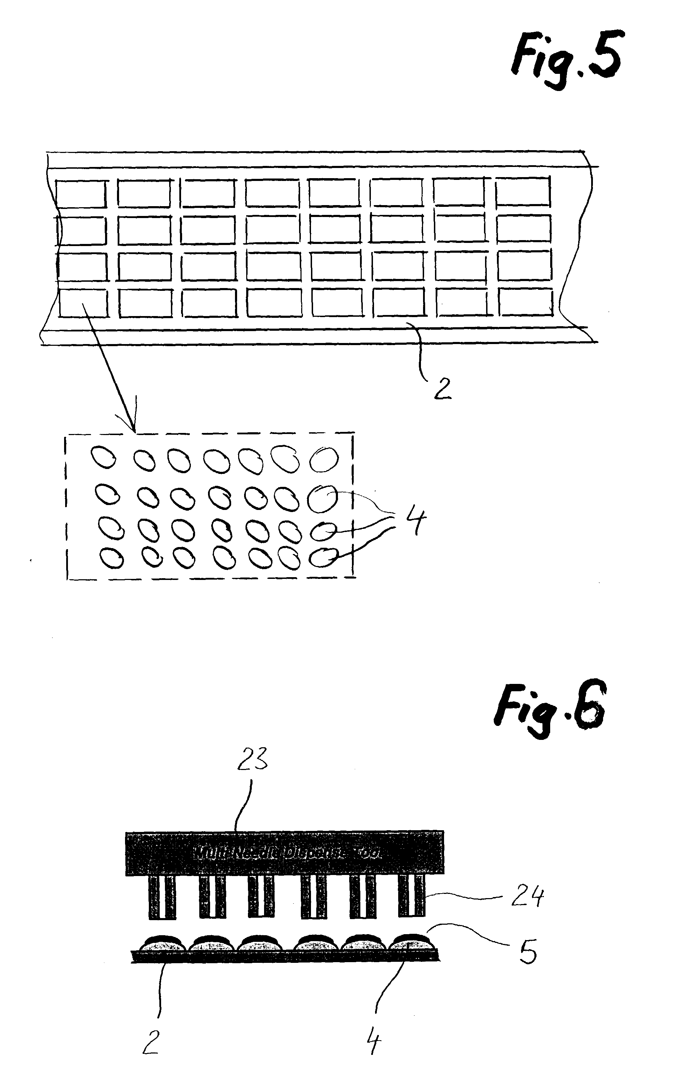

Das Herstellungsverfahren gemäss Figur 4 arbeitet ohne die Bildung von Puffernocken. Dagegen wird an der Dispenserstation 12 gemäss Figur 5a ein Klebstoff 9 auf den Träger 2 aufgetragen, der gleichzeitig die Funktion einer Puffermasse übernimmt. Der Auftrag erfolgt mit Hilfe eines Bewegungsdispensers 34, der aus einer Einfachnadel 35 ein bestimmtes Klebstoffmuster, beispielsweise ein Kreuz oder einen Stern auf den Träger 2 zeichnen kann.

Anstelle eines linienförmigen Musters könnten auch einzelne Flächen aufgetragen werden. Anstelle einer Einfachnadel könnte auch ein Werkzeug mit Mehrfachöffnungen eingesetzt werden.

An der Aufsetzstation 13 wird der Chip auf den Klebstoff 9 aufgesetzt und mit einer geringen Kraft gegen den Träger 2 gepresst, sodass das vorher gezeichnete Klebstoffmuster unter Verdrängung der Luft eine homogene Schicht bildet.

Vorhärtung und/oder Aushärtung erfolgen wiederum auf die gleiche Weise wie beim vorhergehenden Ausführungsbeispiel. Auch die Verdrahtung an der Station 16 ist gleich.

An der Verkapselungsstation 17 wird zwar ebenfalls eine Schutzmasse 7 ausgestossen. Diese muss aber nur noch die elektrischen Leiter 6 und die Seitenkanten des Chips 3 umhüllen. Falls die Pufferschicht nicht homogen ist, sondern in einzelne Abschnitte unterteilt ist, müssen allerdings an der Verkapselungsstation 17 auch diese Hohlräume ausgefüllt werden. Schliesslich sei auch noch darauf hingewiesen, dass die Verdrahrungsstelle nicht zwingend im äusseren Bereich der Bauteile 3 angeordnet sein müssen. Auch eine Verdrahtung innerhalb der Fläche der Bauteile ist in der Paxis möglich.

Figur 5 veranschaulicht die Anordnung einer Gruppe von Absetzpositionen auf einem Träger 2. Jede Position ist mit einer Mehrzahl von Puffernocken 4 versehen. Ein derartiges Feld von Puffernocken wird jeweils mit dem Nadeldispenser gemäss Figur 6 oder auf andere Weise gleichzeitig mit Klebstoff 5 beschichtet.

Figur 7 veranschaulicht die Grössenverhältnisse beispielsweise an den Puffernocken. Demnach beträgt der Durchmesser a im Ansatzbereich beispielsweise 450 µm und die maximale Höhe b liegt bei 150 µm. Die Klebstoffschicht 5 hat einen maximalen Durchmesser von ca. 350 bis 450 µm, ist also vorzugsweise etwas kleiner als die Fläche des Puffernockens.

Figur 8 zeigt schematisch eine Justierstation 36, die unmittelbar an der Aufsetzstation 13 eingesetzt werden kann. Dabei wird mit Hilfe einer Justieroptik 37 der Chip 3 exakt auf den darunterliegenden Träger 2 ausgerichtet, bevor oder nachdem er abgesetzt wird.

Figur 9 zeigt schematisch die Drehbewegung eines Chips 3, zwischen der Wegnahme vom Wafer 38 und dem Aufsetzen auf den Träger. Ein Aufnahmearm 40 bewegt den Chip vom Wafer 38 zu einen Drehhalter 39. Dort wird der Chip gewendet und im nächsten Arbeitstakt von einem Abgabearm 41 wieder aufgenommen und mit der Rückseite gegen den Träger wieder abgelegt.

Figur 10 zeigt schematisch, wie beim Absetzen des Chips 3 an der Aufsetzstation der Träger 2 mittels Unterdruck auf einer Unterdurckauflage 42 fixiert werden kann. Die Unterdruckauflage ist mit Öffnungen versehen, welche zu einer Unterdruckkammer führen. Dort herrscht ein unter dem Atmosphärendruck liegender Druck.

## Patentansprüche

1. Verfahren zum Verkapseln eines elektronischen Bauteils (3), insbesondere eines Halbleiterchips, bei dem das Bauteil im Abstand auf einem flächigen Träger (2) befestigt wird, wobei auf den Träger zuerst ein elastisches Puffermaterial (4, 9) aufgebracht wird, das Bauteil (3) nach dem Aufsetzen auf das Puffermaterial mittel elektrischer Leiter (6) an Kontaktstellen (8) am Träger angeschlossen wird und zuletzt wenigstens die elektrischen Leiter mit einer Schutzmasse (7) umhüllt werden, dadurch gekennzeichnet, dass
- das Puffermaterial (4, 9) und/oder ein Klebstoff (5) in flüssiger oder pastöser Form aus einem Dispenser (23, 32, 34) aufgetragen wird,
- und das Bauteil (3) bei Raumtemperatur auf das Puffermaterial und/oder den Klebstoff aufgesetzt wird,

2. Verfahren nach Anspruch 1, dadurch gekennzeichnet, dass nach dem Aufsetzen des Bauteils das Puffermaterial und/oder der Klebstoff einer Vorhärtung und/- oder einer Aushärtung unterzogen wird.

3. Verfahren nach Anspruch 1 oder 2, dadurch gekennzeichnet, dass zuerst mehrere Puffernocken (4) in einem Schablonendruckverfahren auf dem Träger (2) befestigt werden, dass die Puffernocken ausgehärtet werden und dass vor dem Aufsetzen des Bauteils (3) mit dem Dispenser auf und/oder neben mehreren Puffernocken Klebstoff (5) aufgetragen wird.

4. Verfahren nach Anspruch 3, dadurch gekennzeichnet, dass gleichzeitig aus mehreren Dispenseröffnungen Klebstoff aufgetragen wird.

5. Verfahren nach Anspruch 1, dadurch gekennzeichnet, dass mit dem Dispenser auf den Träger (2) ein Klebstoff (9) aufgetragen wird, der gleichzeitig als Puffermaterial dient.

6. Verfahren nach Anspruch 5, dadurch gekennzeichnet, dass der Klebstoff mit dem Dispenser in der Form einzelner Pufferkörper aufgetragen wird, welche nach dem Aufsetzen des Bauteils vereinzelt bleiben.

7. Verfahren nach Anspruch 5, dadurch gekennzeichnet, dass der Klebstoff mit dem Dispenser als Klebstoffmuster aufgetragen wird, das sich nach dem Aufsetzen des Bauteils zu einer homogenen Schicht verbindet.

8. Verfahren nach einem der Ansprüche 1 bis 7, dadurch gekennzeichnet, dass das Auftragen des Puffermaterials und/oder des Klebstoffs mit dem Dispenser unmittelbar vor dem Aufsetzen des Bauteils (3) und auf der gleichen Maschine (26) erfolgt.

9. Verfahren nach einem der Ansprüche 1 bis 8, dadurch gekennzeichnet, dass der Träger (2) auf dem gleichen Transportsystem (27) am Dispenser und an der Aufsetzvorrichtung für das Bauteil vorbeigeführt wird.

10. Verfahren nach Anspruch 9, dadurch gekennzeichnet, dass der Träger (2) mit dem aufgesetzten Bauteil (3) auf dem gleichen Transportsystem (27) zu einer Vorhärtestation (14) und/oder zu einer Aushärtestation (15) bewegt wird.

11. Verfahren nach Anspruch 9 oder 10, dadurch gekennzeichnet, dass der Träger (2) wenigstens beim Aufsetzen des Bauteils (3) mittels Unterdruck auf einer Auflagefläche (42) fixiert wird.

12. Verfahren nach einem der Ansprüche 1 bis 11, dadurch gekennzeichnet, dass das Bauteil vor dem Aufsetzen auf das Puffermaterial und/oder den Klebstoff bei Raumtemperatur lagemässig justiert wird.

13. Verfahren, insbesondere nach einem der Ansprüche 1 bis 12, bei dem auf dem gleichen Träger Gruppen von Bauteilen befestigt werden, dadurch gekennzeichnet, dass jeweils mehrere Bauteile nacheinander zu einer Gruppe abgesetzt werden und dass die ganze Gruppe gleichzeitig einem Anpressdruck und/oder einer Wärmebehandlung ausgesetzt wird.

14. Verfahren nach Anspruch 13, dadurch gekennzeichnet, dass die gleichzeitige Bearbeitung der Gruppe mit gleichzeitig betätigten Einzelwerkzeugen oder mit einem gemeinsamen Werkzeug erfolgt.

15. Vorrichtung zur Durchführung des Verfahrens, nach einem der Ansprüche 1 bis 11, gekennzeichnet durch eine Dispenserstation (12) für die gesteuerte Abgabe eines flüssigen oder pastösen Mittels und eine Aufsetzstation (13) für das Platzieren eines elektronischen Bauteils (3) auf einem Träger (2), wobei die Dispenserstation und die Aufsetzstation auf einem gemeinsamen Transportmittel (27) durchlaufbar sind und sich die Aufsetzstation (13) in Transportrichtung an die Dispenserstation anschliesst.

16. Vorrichtung nach Anspruch 15, dadurch gekennzeichnet, dass die Dispenserstation (12) einen Dispenser (23) mit mehreren Ausgabeöffnungen (24) aufweist.

17. Vorrichtung nach Anspruch 15, dadurch gekennzeichnet, dass die Dispenserstation (12) einen Dispenser (34) mit wenigstens einer Dispenseröffnung (35) aufweist, welche während der Abgabe des Mittels relativ zum Träger und in einer Ebene parallel zum Träger verschiebbar ist.

18. Vorrichtung nach einem der Ansprüche 15 bis 17, dadurch gekennzeichnet, dass in Transportrichtung nach der Aufsetzstation eine Vorhärtestation (14) und/oder eine Aushärtestation (15) angeordnet ist, in der die aus Träger (2) und Bauteil (3) bestehende Einheit mittels elektromagnetischer Strahlen, insbesondere mittels IR-Strahlen oder UV-Strahlen beaufschlagbar ist.

19. Verkapseltes elektronisches Bauteil, insbesondere Halbleiterchip, hergestellt nach dem Verfahren gemäss einem der Ansprüche 1 bis 14.

20. Bauteil nach Anspruch 19, dadurch gekennzeichnet, dass zwischen dem Träger (2) und dem Bauteil (3) ein Puffermaterial homogen verteilt ist und dass die elektrischen Leiter (6) mit einer Schutzmasse (7) umhüllt sind, welche sich an das Puffermaterial anschliesst.
